# EUROPEAN PATENT SPECIFICATION

(11) **EP 1 866 960 B1**
(45) Date of publication and mention of the grant of the patent: **13.01.2010**
(21) Application number: 06749107.6
(22) Date of filing: 03.04.2006
(51) Int. Cl.: H01L 23/00, H01L 23/29

(54) **RADIATION CURABLE CYCLOALIPHATIC BARRIER SEALANTS**
STRAHLUNGSHÄRTBARE CYCLOALIPHATISCHE SPERRDICHTSTOFFE
AGENTS DE SCELLEMENT BARRIERES CYCLOALIPHATIQUES DURCISSABLES PAR RAYONNEMENT

(30) Priority: 04.04.2005 US 98115
(43) Date of publication of application: 19.12.2007
(73) Proprietor: Henkel AG & Co. KGaA, 40589 Düsseldorf (DE)
(72) Inventor: HERR, Donald, E., Doylestown, PA 18901 (US); KONG, Shengqian, Edison, NJ 08817 (US)
(86) International application number: PCT/US2006/012181
(87) International publication number: WO 2006/107802

(56) References cited:
- DE-A1- 2 200 022
- US-A- 4 547 431
- US-A- 5 155 143
- US-A1- 2003 073 770

## Description

### FIELD OF THE INVENTION

This invention relates to barrier adhesives, sealants, encapsulants, and coatings for use in electronic and opto-electronic devices. (As used in this specification and claims, adhesives, sealants, encapsulants and coatings are similar materials, all having adhesive, sealant, encapsulants and coating properties and functions. When any one is recited, the others are deemed to be included.)

### BACKGROUND

Radiation curable materials have found increased use as coatings, adhesives, and sealants over the past three decades for reasons including low energy consumption during cure, rapid cure speed through both radical and cationic mechanisms, low curing temperature, wide availability of curable materials, and the availability of solvent-free products. These benefits have made such products especially suited for rapidly adhering and sealing electronic and optoelectronic devices that are temperature sensitive or cannot conveniently withstand prolonged curing times. Optoelectronic devices particularly are often thermally sensitive and may need to be optically aligned and spatially immobilized through curing in a very short time period.

Numerous optoelectronic devices are also moisture or oxygen sensitive and need to be protected from exposure during their functional lifetime. A common approach is to seal the device between an impermeable substrate on which it is positioned and an impermeable glass or metal lid, and seal or adhere the perimeter of the lid to the bottom substrate using a radiation curable adhesive or sealant.

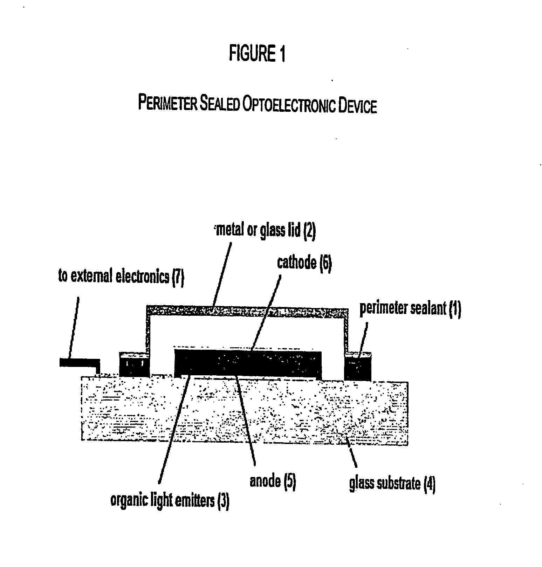

A common manifestation of this package geometry is exemplified in Figure 1, which discloses the use of a radiation curable perimeter sealant (1) to bond a metal or glass lid (2) over an organic light emitting diode (OLED) stack (3) fabricated on a glass substrate (4). Although various configurations exist, a typical device also contains an anode (5), a cathode (6), and some form of electrical interconnect between the OLED pixel/device and external circuitry (7). For the purposes of this invention, no particular device geometry is specified or required aside from one which incorporates an adhesive/sealant material such as a perimeter sealant (1).

In many configurations, as for the example in Figure 1, both the glass substrate and the metal/glass lid are essentially impermeable to oxygen and moisture, and the sealant is the only material that surrounds the device with any appreciable permeability. For electronic and optoelectronic devices, moisture permeability is very often more critical than oxygen permeability; consequently, the oxygen barrier requirements are much less stringent, and it is the moisture barrier properties of the perimeter sealant that are critical to successful performance of the device.

Good barrier sealants will exhibit low bulk moisture permeability, good adhesion, and strong Interfacial adhesive/substrate Interactions. If the quality of the substrate to sealant interface is poor, the interface may function as a weak boundary, which allows rapid moisture Ingress into the device regardless of the bulk moisture permeability of the sealant If the interface is at least as continuous as the bulk sealant, then the permeation of moisture typically will be dominated by the bulk moisture permeability of the sealant itself.

It is important to note that one must examine moisture permeability (P) as the measure of effective barrier properties and not merely water vapor transmission rate (WVTR), as the latter is not normalized to a defined path thickness or path length for permeation. Generally, permeability can be defined as WVTR multiplied by unit permeation path length, and is, thus, the preferred way to evaluate whether a sealant is inherently a good barrier material.

The most common ways to express permeability are the permeability coefficient (e.g. g.mil/(100 in².day.atm)), which applies to any set of experimental conditions, or the permeation coefficient (e.g. g.ml/(100 in².day) at a given temperature and relative humidity), which must be quoted with the experimental conditions in order to define the partial pressure/concentration of permeant present In the barrier material. In general, the penetration of a permeant through some barrier material (permeability, P) can be described as the product of a diffusion term (D) and a solubility term (S): P = DS

The solubility term reflects the affinity of the barrier for the permeant, and, In relation to water vapor, a low S term is obtained from hydrophobic materials. The diffusion term is a measure of the mobility of a permeant in the barrier matrix and is directly related to material properties of the barrier, such as free volume and molecular mobility. Often, a low D term is obtained from highly crosslinked or crystalline materials (in contrast to less crosslinked or amorphous analogs). Permeability will increase drastically as molecular motion increases (for example as temperature is increased, and particularly when the T_{g} of a polymer is exceeded).

Logical chemical approaches to producing improved barriers must consider these two fundamental factors (D and S) affecting the permeability of water vapor and oxygen. Superimposed on such chemical factors are physical variables: long permeation pathways and flawless adhesive bondlines (good wetting of the adhesive onto the substrate), which improve barrier performance and should be applied whenever possible. The Ideal barrier sealant will exhibit low D and S terms while providing excellent adhesion to all device substrates.

It is not sufficient to have *only* a low solubility (S) term or *only* a low diffusivity (D) term in order to obtain high performance barrier materials. A classic example can be found in common siloxane elastomers. Such materials are extremely hydrophobic (low solubility term, S), yet they are quite poor barriers due to their high molecular mobility due to unhindered rotation about the SI-O bonds (which produces a high diffusivity term (D). Thus, many systems that are merely hydrophobic are not good barrier materials despite the fact that they exhibit low moisture solubility. Low moisture solubility must be combined with low molecular mobility and, thus, low permeant mobility or diffusivity.

For liquid materials that are radiation or thermally cured to solid sealants, such as the inventive compositions, the attainment of lower molecular mobility within the cured matrix is approached through high crosslink density, microcrystallinity, or close packing of molecular backbones between the crosslinked portions of the matrix.

### BRIEF DESCRIPTION OF THE DRAWINGS

Figure 1 Is a depiction of a Perimeter Sealed Optoelectronic Device;
Figure 2 is a depiction of a Cycloaliphatic Vinyl Ether Synthesis; Figure 3 is PhotoDSC Analysis of the Basic Q43/TAIC Thiol-ene System (Formulation 7); and
Figure 4 is Real-Time UV-FT-IR Analysis of the Basic Q43/TAIC Thiol-ene System (Formulation 7).

### SUMMARY OF THE INVENTION

The inventors have discovered that certain resin and resin/filler systems provide superior barrier performance through the Incorporation of a radiation-curable material that possesses a cycloaliphatic backbone. Such cycloaliphatic barrier materials may be used alone or in combination with other resins and various fillers. The resulting compositions exhibit a commercially useful cure rate, a balance of high crosslink density, rigidity, and molecular packing (low permeant mobility/diffusivity term, D), hydrophobicity (low water solubility term, S), and adhesion (strong adhesive/substrate interfaces) to make them effective for use in sealing and encapsulating electronic, optoelectronic, and MEMS devices.

### DETAILED DESCRIPTION OF THE INVENTION

This invention is a curable barrier adhesive or sealant comprising: (a) a curable resin **characterized in that** it has (i) a cycloaliphatic (or alicyclic) backbone, and (ii) at least one reactive functional group present at a level that provides an equivalent weight of less than 400 grams per mole of reactive functional group; as defined in claim 1 and (b) an initiator. The words "at least one reactive functional group" is deemed to mean one or more of the same type of reactive functional group and/or one or more types of reactive functional groups; the overall functional group equivalent weight will remain less than 400 grams per mole. In another embodiment, the radiation-curable barrier adhesive or sealant further comprises (c) a reactive or non-reactive resin (other than the resin with a cycloaliphatic backbone). In a further embodiment, the curable barrier adhesive or sealant further comprises (d) a filler. Radiation curable sealants are often preferred (for the reasons noted in the Background section) but thermally curable sealants are also useful depending on the specific application.

Within this specification, the term radiation is used to describe actinic electromagnetic radiation. Actinic radiation is defined as electromagnetic radiation that induces a chemical change in a material, and for purposes within this specification will also include electron-beam curing. In most cases electromagnetic radiation with wavelengths in the ultraviolet (UV) and/or visible regions of the spectrum are most useful.

Within this specification, the terms cycloaliphatic or alicyclic refer generally to a class of organic compounds containing carbon and hydrogen atoms joined to form one or more rings, which may contain other atoms, such as, halogens (e.g. Cl, Br, I), heteroatoms (e.g. O. S, N), or substituent groups (e.g. OR, SR, NR₂ in which R is a linear or branched alkyl or cycloalkyl or aryl group). In general, cycloaliphatic resins are defined as resins that contain a cyclic carbon-based ring structure in their backbone, which cyclic carbon backbone may have heteroatoms within the backbone or attached to it. It is preferable that the cycloaliphatic resin backbone be composed primarily of carbon, hydrogen and halogen atoms. The cycloaliphatic radiation-curable resins (a) may be small molecules, oligomers, or polymers depending on the desired end use application and materials properties.

The compounds with cycloaliphatic backbones are selected from the group consisting of 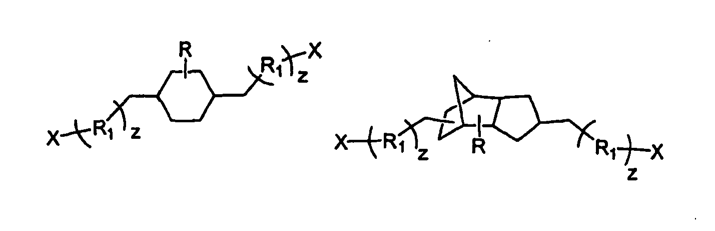 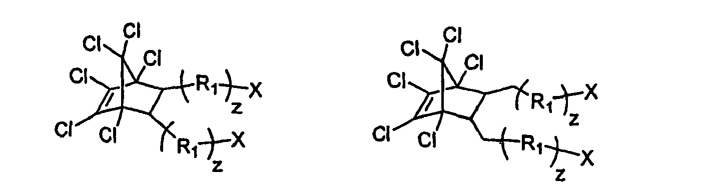 in which X is a reactive group independently selected from epoxies, selected from glycidyl epoxy, aliphatic epoxy, and cycloaliphatic epoxy; acrylate and methacrylate; itaconate; maleimide; vinyl, propenyl, crotyl, allyl, and propargyl ether and thlo-ethers of those groups; maleate, fumarate, and cinnamate esters; styrenic; acrylamide and methacrylamide; chalcone; thiol; allyl, alkenyl, and cycloalkenyl; R is hydrogen, alkyl or halogen; R₁ is linear or branched alkyl, or cycloalkyl and may contain heteroatoms and z=0 or 1.

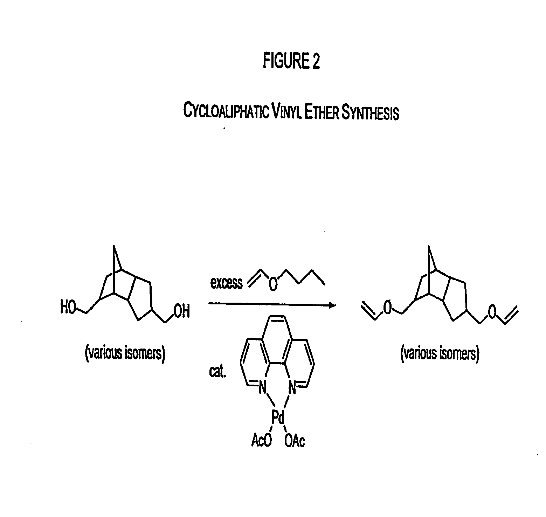

When n, k, and I in the above structures are 0, and X is a form of epoxy, X can be attached to the cycloaliphatic backbone by a direct bond or can be a part of the cycloaliphatic backbone. Other suitable compounds include those selected from the group having the structures: 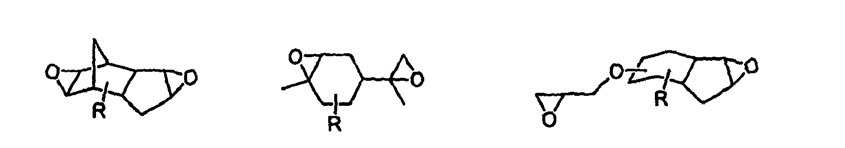 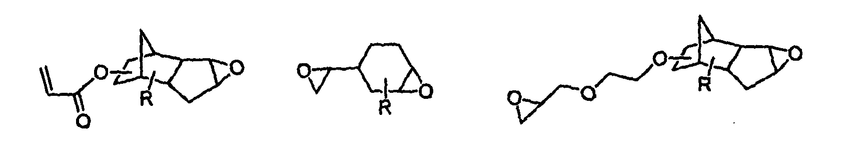 and 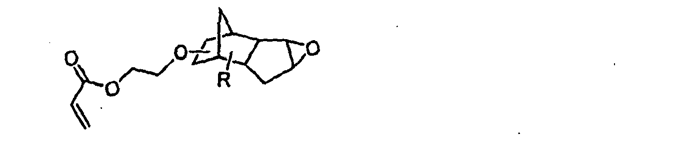 in which R is hydrogen, an alkyl group, a heteroalkyl group, or a halogen. Further examples of suitable resins include dicyclopentadiene (DCPD) dimethylol diacrylate and the cycloaliphatic vinyl ether derived from DCPD dimethylol as shown in Figure 2.
Additional suitable radiation-curable resins with cycloaliphatic backbones are those selected from the group consisting of 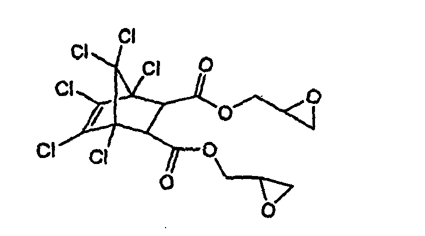 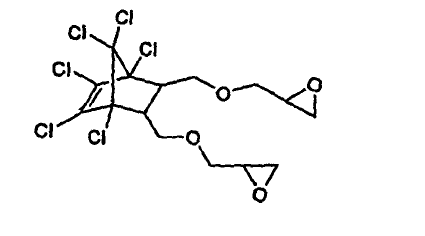 and

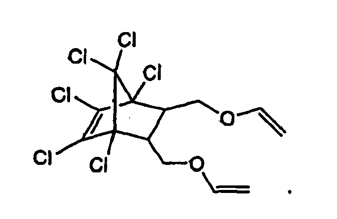

In one embodiment the curable resin for the moisture-barrier sealant is 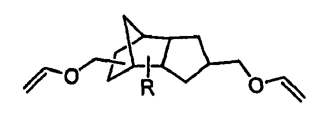 in which R is hydrogen, alkyl (e.g. methyl) or halogen (e.g. chlorine). In another embodiment the curable resin for the moisture-barrier sealant is 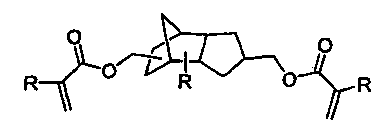 In which R is hydrogen, alkyl (e.g. methyl) or halogen (e.g. chlorine).

As disclosed above, suitable curable functionalities on the resins (a) include any known to those with experience in the field of UV and thermally curable materials and filled polymer composites. Common curable functionalities include, but are not limited to, epoxies, selected from glycidyl epoxy, aliphatic epoxy, and cycloaliphatic epoxy; acrylate and methacrylate; itaconate; maleimide; vinyl, propenyl, crotyl, allyl, and propargyl ether and thio-ethers of those groups; maleate, fumarate, and cinnamate esters; styrenic; acrylamide and methacrylamide; chalcone; thiol; allyl, alkenyl, and cycloalkenyl. The polymerization mechanism upon irradiation or heating is not limited, but is typically either a radical or cationic process. The inventors have found, within predefined boundaries of overall crosslink density, that the type of reactive functional groups present are not as critical to barrier properties as the nature of the backbone to which those reactive functional groups are attached.

The reactive functionality will be present at a level that provides an equivalent weight of less than 400 grams per mole of reactive functional group. The definition of equivalent weight is that commonly used by those skilled In the art: it is the molecular weight divided by the total functionality (e.g. epoxy, acrylate, maleimide, etc.). Equivalent weight is the mass per mole of reactive group. In general, molecules with low equivalent weights are highly functional, and will provide highly crosslinked matrices after curing (assuming good conversion upon cure).

In general, highly crosslinked materials (low uncured equivalent weights) produce rigid, high glass transition temperature (Tg), low free volume materials. It is the inventors' understanding that this is not a universal correlation, and that the nature of the matrix also has an effect on free volume. For example, non-homogeneous crosslinking or microvoids may produce unexpectedly higher free volume than might be expected from simple Tg correlations. Nonetheless, the inventors have verified that highly crosslinked materials tend to yield better barrier materials, other factors held constant. As shown in the examples, high crosslink density alone, however, does not guarantee good barrier properties.

It is also beneficial if the permeant has low solubility in the barrier material. With respect to moisture, if the barrier material is hydrophobic, this results in low moisture solubility in the cured adhesive/sealant barrier material, which reduces moisture permeability. Conversely, hydrophobic materials are not *necessarily* good barrier materials, particularly if they have low crosslink density (high uncured equivalent weight) or exhibit high mobility/high free volume In the cured state. Within this specification, the term hydrophobic means absorbing less than 5.00 weight % water at 85°C and 85% relative humidity (RH).

The inventors have discovered that certain cycloaliphatic backbones, those with low functional group equivalent weight, can provide low uncured viscosity while packing efficiently in a radiation or thermally cured system. Such backbone molecular packing, combined with the high crosslink density afforded by the low functional group equivalent weight, results in low cured matrix mobility, and accordingly, in low permeant mobility.

Additionally, the cycloallphatic-based compositions tend to be hydrophobic as they are primarily hydrocarbon in nature. This hydrophobicity results in low moisture solubility in the cured material, which also reduces moisture permeability. The use of primarily cycloaliphatic materials to achieve this combination of low permeant mobility and low moisture solubility is novel and unexpected among curable barrier materials.

Both suitable radiation curable resins and suitable photoinitiator for radiation curable resins may be any of those commonly described in the open literature. Representative examples may be found in literature sources such as Fouassier, J-P., Photoinitiation, Photopolymerization and Photocuring Fundamentals and Applications 1995, Hanser/Gardner Publications, Inc., New York, NY. Chapter 6 is a particularly useful overview of the various classes of radiation curable resins and photoinitiators used by those practiced in the art. Exemplary photoinitiators are disclosed in Ionic Polymerizations and Related processes, 45-60, 1999, Kluwer Academic Publishers; Netherlands; J.E. Puskas et al. (eds.). Curing mechanisms may be any of those described therein and most frequently the resin system cures through either a radical or cationic mechanism.

For radiation curable sealants, the initiator (b) will be a photoinitiator. The selection of photoinitiator (b) for the Inventive radiation curable barrier adhesives is familiar to those skilled In the art of radiation curing. The selection of an appropriate photoinitiator system is highly dependent on the specific application in which the barrier sealant is to be used. A suitable photoinitiator is one that exhibits a light absorption spectrum that is distinct from that of the resins, fillers, and other additives In the radiation curable system. If the sealant must be cured through a cover or substrate, the photoinitiator will be one capable of absorbing radiation at wavelengths for which the cover or substrate is transparent. For example, if a barrier sealant is to be cured through a sodalime glass coverplate, the photoinitiator must have significant absorbance above ca. 320 nm, which is the UV cut-off of sodalime glass. In some cases, it is anticipated that the use of photosensitizers will be helpful.

Generally, for systems that cure via a radical mechanism, either Type I (cleavage) or Type II (H abstraction) radical photoinitiators may be used. Small molecule, polymeric, or polymerizeable photoinitiators may be used. For many applications, common cleavage photoinitiators, such as those offered by Ciba Specialty Chemicals, are useful. Preferred photoinitiators include Irgacure 651, Irgacure 907, and Irgacure 819, all sold by Ciba. Alternatively, a preferred class of photoinitiators are polymer-bound aromatic ketones, or polymeric Type II photoinitiators. Such systems do not produce small molecule photo by-products, and therefore tend to produce less odor, outgassing, and extractable components upon UV cure. Such systems may or may not require a photosensitizer, depending on the specific application and resin system used.

Preferred cationic photoinitiators include diaryllodonium salts and triarylsulfonium salts. Well known commercially available examples include UV9380C (GE Silicones), PC2506 (Polyset), Rhodorsil 2074 (Rhodia), and UVI-6974 (Dow). If curing through certain covers or substrates, an appropriate photosensitizer should be used to assure adequate light absorption by the photoinitiating system. Preferred sensitizers for diaryliodonium salts are isopropylthioxanthone (often sold as a mixture of 2- and 4-isomers) and 2-chloro-4-prcpoxythloxanthone. The selection of an efficient cationic photoinitiating system for a particular curing geometry and resin system is known to those skilled in the art of cationic UV curing, and is not limited within the scope of this Invention.

Less common initiating systems, such as photogenerated bases (e.g. photogenerated amines or photogenerated polythiols) are also anticipated in cases where such basic catalysts, initiators, and curing agents are appropriate.

The inventive cycloaliphatic barrier adhesives may be cured thermally as well as photochemically. Appropriate thermal initiators are well known to those skilled in the art of thermoset chemistry, and will vary widely depending on resin type, curing mechanism, and end use of the barrier sealant.

For radically curable sealants, various radical thermal initiators are useful. Common examples include azo-type initiators such as 2,2'-azobisisobutyronitrile (sold by various vendors, Including DuPont as Vazo 64), peroxyketals such as 1,1'-di(*t*-amylperoxy)cyclohexane (sold by Witco as USP-90MD), peresters such as *t*-amyl peroxypivalate (sold by Akzo as Trigonox 125-C75), and alkylperoxides, such as, di-cumyl peroxide (sold by various vendors such as Witco).

Various thermal cationic initiators are also contemplated. In general, such catalysts include any sort of Brφnsted or Lewis acids, often in the form of a latent thermal acid generator. Examples of latent thermal acid generators include, but are not limited to, diaryliodonium salts, benzylsulfonium salts, phenacylsulfonium salts, N-benzylpyridinium salts, N-benzylpyrazinium salts, N-benzylammonium salts, phosphonium salts, hydrazinium salts, and ammonium borate salts. An example of a useful diaryliodonium salt thermal cationic initiator is PC2506 (Polyset). Diaryliodonium salts can often be accelerated (made to initiate at low temperature with acceptable latency) by adding electron donating co-initiators such as benzopinacol. The initiation mechanism then essentially becomes one of redox reduction of the diaryliodonium salt by a species generated through the thermal decomposition of the co-initiator. Other representative examples of thermally activated cationic catalysts include sulfonates and sulfonate salts (available from King Industries under the tradename of Nacure and K-cure).

The cycloaliphatic resin component may optionally be blended with one or more other reactive or non-reactive resin components (c). These optional resins may be used to modify specific properties of the compositions, such as toughness, flexibility, adhesion to certain substrates, or to minimize weight loss during or after cure. Typically, it is beneficial to use as much cycloaliphatic material as is practical. The amount of these other resin components will varying depending on the application, processing conditions, and barrier requirements, but will generally fall within the range of 1-90% of the total resinous portion of the barrier sealant composition.

If the second (non-cycloaliphatic) resin component is reactive, it may contain any of the reactive groups described previously for the cycloaliphatic resin component. As such, common reactive optional resins include, but are not limited to epoxy resins, acrylic resins, maleimide resins, vinyl and propargyl ether resins, fumarate esters, maleate esters, cinnamate esters, chalcones, polythiols, and allylated molecules.

Representive epoxy resins are glycidyl ethers and cycloaliphatic epoxies. Various sources and variations of glycidyl ethers are well known to those skilled in the art. Representative aromatic liquid glycidyl ethers include epoxy resins such as Epikote 862 (essentially bisphenol F diglycidyl ether) or Epikote 828 (essentially bisphenol A diglycidyl ether). Preferred solid glycidyl ethers include Epon 1031, Epon 164, SU-8, DER 542 (brominated bisphenol A diglycidyl ether), RSS 1407 (tetramethylbiphenyldiglycidyl ether), and Erisys RDGE (resorcinol diglycidyl ether). All of these Epikote^{®} and Epon^{®} glycidyl ethers are available from Resolution Performance Products. Erisys RDGE^{®} is available from CVC Specialty Chemicals, Inc. Representative non-aromatic glycidyl epoxy resins include EXA-7015 available from Dainippon Ink & Chemicals (hydrogeneated bisphenol A diglycidylether). Representative cycloaliphatic epoxy resins include ERL 4221 and ERL 6128 available from Dow Chemical Co.

Representative vinyl ether molecules such as Rapicure-CHVE (cyclohexanedimethylol divinyl ether), Rapicure-DPE-3 (tripropylene glycol divinyl ether) or Rapicure-DDVE (dodecyl vinyl ether) are readily available from International Specialty Products. Analogous vinyl ethers are also available from BASF. Vinyl ether-terminal urethanes and polyesters are available from Morflex. Reactive unsaturated polyesters are available from Reichold. A wide variety of acrylate monomers, oligomers and polymers are available from vendors such as Sartomer Corporation, and may be useful as reactive resin additives. These include various mono- and multifunctional acrylic monomers, acrylated polyurethanes, acrylated polyesters, and metal diacrylates. Acrylated siloxanes may be obtained from Gelest and others.

Optional fillers (d) may vary widely and are well known to those skilled in the art of composite materials. Common fillers include, but are not limited to ground quartz, fused silica, amorphous silica, talc, glass beads, graphite, carbon black, alumina, clays, mica, vermiculite, aluminum nitride, and boron nitride. Metal powders and flakes consisting of silver, copper, gold, tin, tin/lead alloys, and other alloys are contemplated. Organic filler powders such as poly(tetrachloroethylene), poly(chlorotriflouroethylene), and poly(vinylidene chloride) may also be used. Fillers that act as desiccants or oxygen scavengers, including but not limited to, CaO, BaO, Na₂SO₄, CaSO₄, MgSO₄, zeolite, silica gel, P₂O₅, CaCl₂, and Al₂O₃ may also be utilized.

### EXAMPLES

EXAMPLE 1. UV CURABLE CYCLOALIPHATIC ACRYLIC BARRIERS.

Several UV curable acrylate compositions were formulated by mixing several structurally distinct acrylate resins with a polythiol, a photoinitiator, and fumed silica in parts by weight as shown in Table 1.

| TABLE 1. UV CURABLE ACRYLATE FORMULATIONS | | | | | |
|---|---|---|---|---|---|
| FORMULA NUMBER | PARTS ACRYLATE RESIN | ACRYLATE EQUIVALENT WEIGHT | PARTS POLYTHIOL | PARTS PHOTO-INITIATOR | PARTS FUMED SILICA |
| | | (G/MOL) | | | |
| 1 | 89.3 | 113 | 3.8 | 1.9 | 5.0 |
| | HDDA | | | | |
| | (SR238) | | | | |
| 2 | 89.3 | 148 | 3.8 | 1.9 | 5.0 |
| | TMPTA | | | | |
| | (SR351) | | | | |
| 3 | 89.3 | 152 | 3.8 | 1.9 | 5.0 |
| | DCPDDA | | | | |
| | (SR833) | | | | |
| 4 | 94.0 | -1400 | 4.0 | 2.0 | 0 |
| | pBD DMA | | | | |
| | (CN 301) | | | | |

HDDA is hexanediol diacrylate; TMPTA is trimethylolpropane triacrylate; pBD DMA is poly(butadiene)dimethacrylate; DCPDDA is dicyclopentadienedimethylol diacrylate.

Q-43 is pentaerythritol tris(3-mercapto-propionate) and is a polythiol, which acts to reduce oxygen inhibition and as a flexibilizer. The Q-43 polythiol has the structure:

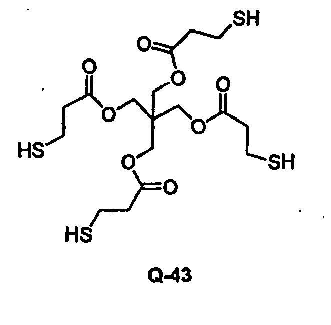

The photoinitiator used was Irgacure 651, obtained from Ciba Specialty Chemicals. The fumed silica acts as a thixotrope to allow high quality films to be formed and purged with nitrogen prior to cure without dewetting the release liner substrate.

The formulation resin components were combined and magnetically mixed until the photoinitiator dissolved. The fumed silica was added and hand mixed briefly, followed by three passes on a three roll mill. No particles greater than 10 µm were observed in a Hegeman gauge test after milling. Formula 4 did not require fumed silica thixotrope due to its inherently higher viscosity relative to the other formulations.

Drawdown films of the filled formulations were made on release-coated Mylar substrates. These films were placed in a flow-through chamber and purged with nitrogen for three minutes, followed by UV curing in a Dymax stationary curing unit. UV dose was 3J UVA/cm², at an intensity of ca. 45 mW UVA/cm² as measured using an EIT compact radiometer. The cured films were then removed from the release Mylar substrate. The equilibrium bulk moisture permeation coefficient was measured using a Mocon Permatran-W 3/33 instrument at 50°C/100% relative humidity (RH). Results are provided in Table 2 below.

| TABLE 2. MOISTURE PERMEATION COEFFICIENR OF ACRYLATE FORMULATIONS | | | |
|---|---|---|---|
| FORMULATION NUMBER | ACRYLATE RESIN | ACRYLATE EQUIVALENT WEIGHT | MOISTURE PERMEATION COEFFICIENT (AT 50°C/100% RH [g.mil/100 in².day]) |
| 1 | HDDA | 113 | 39.7 |
| 2 | TMPTA | 148 | 18.5 |
| 3 | DCPDDA | 152 | 8.7 |
| 4 | pBD DMA | ~1400 | 92.7 |

Several important concepts can be noted from this simple example. First, the three resin systems 1 through 3 have low equivalent weight, and are thus expected to produce highly crosslinked materials upon cure. Yet, the cycloaliphatic resin-based system (formulation 3), exhibits significantly lower bulk permeability than the other two acrylate formulations (formulations 1 and 2). Also, HDDA (formulaton 1) and DCPDDA (formulation 3) are both considered hydrophobic acrylate materials (TMPTA, formulation 2, is fairly hydrophobic as well), yet again the cycloaliphatic resin provides superior moisture barrier properties.

The film based on a poly(butadiene) backbone (formulation 4) exhibited, by far, the highest moisture permeability. This demonstrates that, despite the well known extremely hydrophobic nature of the poly(butadiene) backbone of pBD DMA, the low crosslink density of this film results In high molecular mobility and high permeation coefficient. Hydrophobicity alone does not yield a good barrier material.

Thus, although the HDDA, TMPTA, and pBD DMA molecules exhibit some properties that lead one to expect that they might produce good moisture barriers, it is not *just* hydrophobicity or *just* high crosslink density, but the unique combination of backbone structure/packing and high crosslink density that provide the DCPDDA-based formulation 3 with clearly superior moisture barrier properties.

EXAMPLE 2. UV CURABLE CVCLOAUPHATIC THIOL-ENE BARRIER MATERIALS

Several UV curable thiol-ene formulations were prepared according to Table 3 using the same polythiol (Q-43) as in Example 1, various ene components, and a photoinitiator.

| TABLE 3. UV CURABLE CYCLOALIPHATIC THIOL-ENE BARRIER MATERIALS AND UV CURING | | | | | | |
|---|---|---|---|---|---|---|
| | Formula | | | | | |
| | 5 | 6 | 7 | 8 | 9 | 10 |
| PARTS BY WEIGHT Q-43 THIOL | 34 | 43 | 60 | 60 | 53 | 53 |
| PARTS BY WEIGHT DAC ENE | 65 | 41 | | | | |
| PARTS BY WEIGHT TAIC ENE | | 14 | 39 | 39 | | |
| PARTS BY WEIGHT TABPA ENE | | | | | 45 | 45 |
| PARTS BY WEIGHT PHOTO-INITIATOR | 1 | 2 | 1 | 1 | 2 | 2 |
| UV DOSE JOULES UVA PER CM² | 3 | 3 | 3 | 3 | 3 | 3 |
| THERMAL BUMP | | 70°C 10 min | | 70°C 10 min | | 70°C 10 min |
| PHOTOPOLYMERIZATION ENTHALPY J/G | -150 | | -231 | | -117 | |
| TIME TO PEAK EXOTHERM (SECONDS) | 4.0 | | 4.0 | | 2.4 | |

Q-43 is pentaerythritol tetrakis(3-mercpatopropionate); DAC is diallylchlorendate; TAIC is triallyl isocyanurate (with 100 ppm BHT stabilizer); TABPA Is tetraallyl bisphenol A.

The structures of the polyenes are

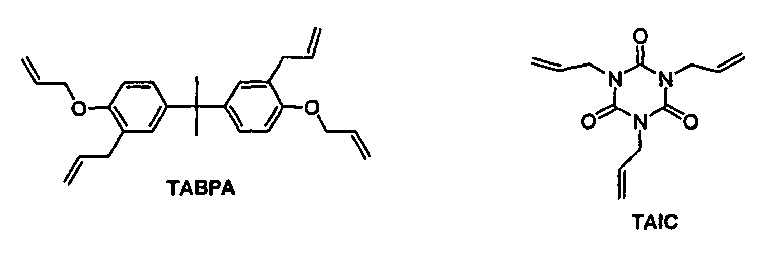

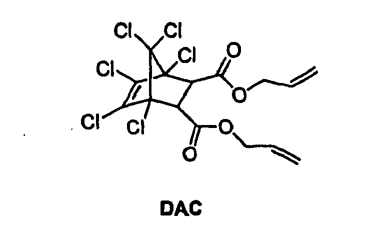

The photoinitiator was Irgacure 651, obtained from Ciba Specialty Chemicals and used at a level appropriate for each formulation

Drawdown films of the various formulations were made on release-coated Mylar substrates or directly onto PTFE-coated aluminum plates. (Some haziness was noted in formulations 9 & 10.) These films were UV cured in a Dymax stationary curing unit. UV dose was 3J UVA/cm², at an intensity of ca. 45 mW UVA/cm² as measured using an EIT compact radiometer. The cured films were then removed from the release Mylar or PTFE-coated plate. In some indicated cases a light thermal post-cure (thermal bump) was Included in the cure schedule, as thiol-ene curing can be induced via both radiation or heat.

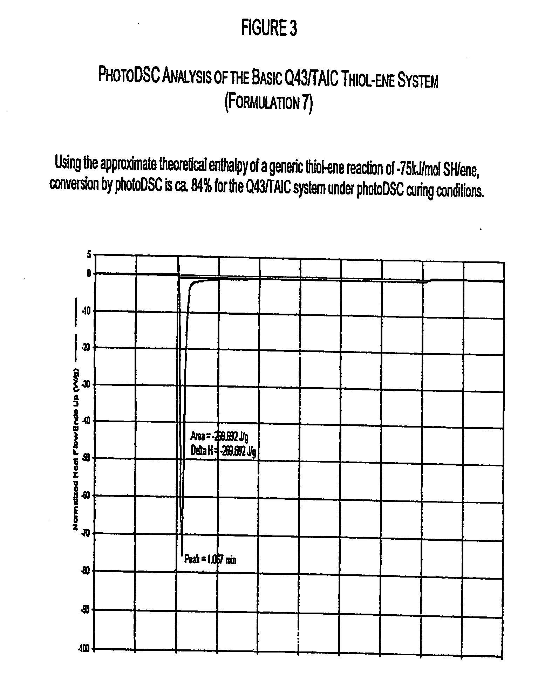

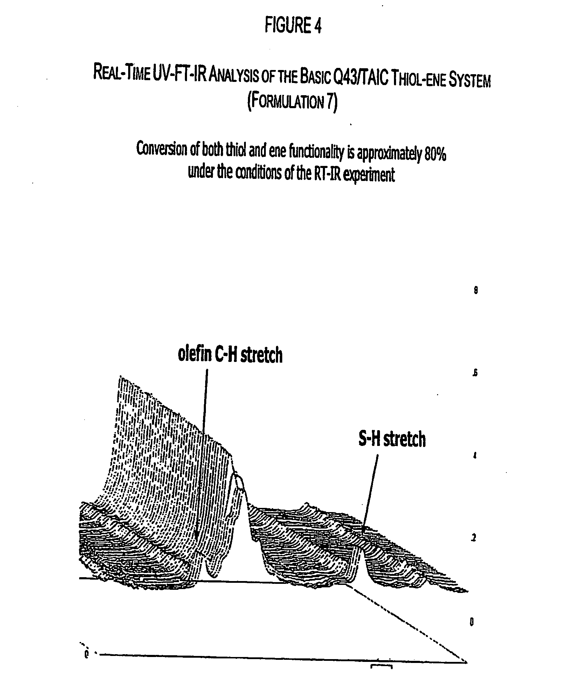

It was attempted to achieve as close to full cure as possible using light or mild heating in order to minimize variations in barrier properties that may arise from varying degrees of conversion during the curing process. PhotoDSC analysis of the formulations indicated that each has significant enthalpy of polymerization and good UV cure kinetics under the low intensity conditions present in the photoDSC (1∼10 mW/cm²). The results for formulations 5, 7, and 9 are reported in Table 3. Representative photoDSC and real-time FT-IR data collected for formulation 7 are provided in Figure 3 and Figure 4 respectively. The equilibrium bulk moisture permeation coefficient was measured using a Mocon Permatran-W 3/33 instrument at 50°C/100% relative humidity (RH). Results are provided in Table 4 below.

| TABLE 4. MOISTURE PERMEATION COEFFICIENT OF THIOL-ENE SYSTEMS | | | | |
|---|---|---|---|---|
| FORMULA NUMBER | THIOL | ENE | COMMENTS | MOISTURE PERMEATION COEFFICIENT |
| | | | | (50°C, 100% RH |
| | | | | (g.mil/100in².day]) |
| 5 | Q-43 | DAC | UV cure only | 14.4 |
| 6 | Q-43 | DAC/TAIC | UV + thermal bump | 15.6 |
| 7 | Q-43 | TAIC | UV cure only | 16.0 |
| 8 | Q-43 | TAIC | UV + thermal bump | 15.3 |
| 9 | Q-43 | TABPA | UV cure only | 47.5 |
| 10 | Q-43 | TABPA | UV + thermal bump | 54.5 |

When the thiol component is held constant and the ene component is varied, the best barrier properties are obtained when a cycloaliphatic ene is utilized (formula 5). Formulas 6 and 7 exemplify that as one dilutes (formula 6) or replaces (formula 7) the cycloaliphatic ene component with another ene (TAIC in this case), moisture permeability steadily Increases.

It is notable that the internal double bond of DAC is not as reactive as its allyl groups, and as such the trifunctional ene TAIC should produce higher crosslink densities relative to DAC as indicated by photoOSC exotherm. The data show that the TAIC-containing formulations exhibit inferior moisture barrier properties relative to the DAC-containing formulations, even though the TAIC-containing formulations have higher crosslink densities when cured relative to the DAC films. The cycloaliphatic nature of the DAC ene is presumed to play a role In this phenomenon, and the chlorination of DAC may contribute favorably to its moisture barrier properties as well.

The formulation that utilizes TABPA in place of DAC (formulation 9) also exhibits higher moisture permeability relative to the DAC/Q-43 system (formula 5). Thus, despite the fact that the TABPA polyene is quite hydrophobic (due to the lack of polar functionality) and of higher functionality than DAC (4 vs. 2-3), it cannot match the moisture barrier performance obtained when the cycloaliphatic DAC polyene is utilized. It is generally notable that the use of a thermal post cure (formulas 6, 8 and 10) does not appreciably affect moisture permeability or the aforementioned conclusions in this series of experiments.

EXAMPLE 3. EPOXYNINYL ETHER UV CURABLE BLENDS

Several formulations were prepared using the components and parts by weight listed in Table 5 below. The photoinitiator was UV9380C obtained from GE Silicones. The structures of the vinyl ethers are as follows:

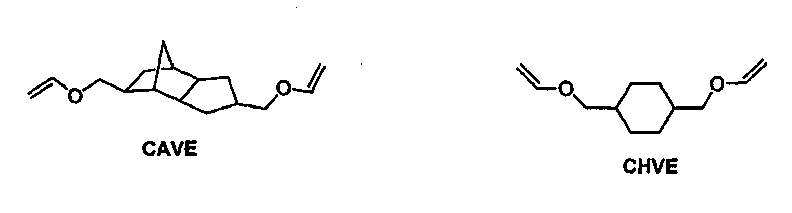

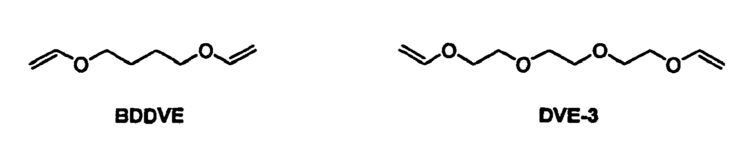

The components were handmixed, followed by mixing in a Speedmixer DAC 150 FV2-K (FlackTek Inc.) for two minutes at 3000 rpm. The resulting pastes were coated onto release-coated PET film using a drawdown bar, and the resulting wet films were UV cured in a Dymax stationary curing unit. UV dose was 3J UVA/cm², at an intensity of ca. 45 mW UVA/cm² as measured using an EIT compact radiometer. The cured epoxy/vinyl ether films were removed from the PET backing and analyzed. The equilibrium bulk moisture permeation coefficient of the films was measured using a Mocon Permatran-W 3/33 instrument at 50°C/100% relative humidity (RH).

| TABLE 5. BARRIER SEALANTS COMPRISING VINYL ETHER/EPOXY BLENDS | | | | |
|---|---|---|---|---|
| RESIN COMPONENT | FORMULA 11 | FORMULA 12 | FORMULA 13 | FORMULA 14 |
| | (PARTS BY WEIGHT) | (PARTS BY WEIGHT) | (PARTS BY WEIGHT) | (PARTS BY WEIGHT) |
| Aromatic Epoxy | 56 | 56 | 56 | 56 |
| CAVE | 37 | | | |
| CHVE | | 37 | | |
| BDDVE | | | 37 | |
| DVE-3 | | | | 37 |
| Photoinitiator | 2 | 2 | 2 | 2 |
| Fumed Silica | 5 | 5 | 5 | 5 |

| TABLE 6. VINYL ETHER COMPONENT VS. MOISTURE PERMEABILITY | | | | |
|---|---|---|---|---|
| VINYL ETHER COMPONENT | CAVE | CHVE | BDDVE | DVE-3 |
| VINYL ETHER EQUIVALENT WEIGHT | 124.2 | 98.1 | 71.1 | 101.1 |
| FORMULA # | 11 | 12 | 13 | 14 |
| MOISTURE PERMEATION COEFFICIENT (g.mil/100ln².day @ 50°C/100% RH) | 5.7 | 8.4 | 71.1 | 111.7 |

As can be seen from Tables 5 and 6, the two formulations containing cycloaliphatic vinyl ether components (formulations 11 and 12, CAVE and CHVE respectively) exhibited the lowest moisture permeabilities. In addition to both being hydrophobic cured materials, these results are due to the unique combination of high crosslink density and cycloaliphatic backbone packing in these two formulations.

It is notable that butane diol divinyl ether (BDDVE) possesses a lower equivalent weight than either dicyclopentadienedimethylol divinyl ether (CAVE) or cyclohexanedimethylol divinyl ether (CHVE). As such, its formulation with an aromatic epoxy (formulation 13) should exhibit a higher cured crosslink density relative to formulations derived from CAVE and CHVE (formulations 11 and 12 respectively). As a result of their chemically similar structures, CAVE, CHVE, and BDDVE should have similar hydrophobicity, as should their respective cured formulations. Although all three of these formulations exhibit both high crosslink density (low vinyl ether equivalent weight) and hydrophobicity, the CAVE and CHVE-based formulations, which are also cycloaliphatic, exhibit better moisture barrier performance. Thus, given hydrophobicity, it is the unique combination of high crosslink density and cycloaliphatic backbone properties that produces superior barrier performance.

Although the combination of high crosslink density and hydrophobicty obtained by using BDDVE produces a product with moisture barrier properties, the additional cycloaliphatic structural characteristic present in CAVE and CHVE yields unexpected improvements in barrier performance.

The fourth formulation containing triethylene glycol divinyl ether (DVE-3, formulation 14) exhibited much higher moisture permeability, presumably due to the hydrophilic nature of its backbone (and the resulting higher solubility of water in the polymer matrix) and the flexibility/mobility of its poly(ether) backbone (resulting in higher permeant diffusivity).

EXAMPLE 4. EPOXY/CVCLOAUPHATlC VINYL ETHER-BASED UV-CURABLE MOISTURE BARRIER SEALANT COMPOSITION

A syringe dispensable, UV-curabte barrier sealant was formulated under short wavelength-visible filtered lighting using the components as shown in Table 7.

| TABLE 7. EPOXY/CYCLOALIPHATIC VINYL ETHER BARRIER SEALANT | |
|---|---|
| RESIN/FILLER | PARTS BY WEIGHT |
| Liquid aromatic epoxy | 18.91 |
| Cycloaliphatic vinyl ether (CAVE) | 12.61 |
| Silane adhesion promoter | 0.17 |
| Photoinitiator | 1.17 |
| Isopropyl thioxanthone (ITX) | 0.15 |
| Silica | 66.00 |
| Fumed silica thixotrope | 1.00 |

The resin components were combined and mixed to dissolve the ITX photosensitizer. The silica fillers were subsequently added and hand mixed until bulk wet-out was obtained. The paste was then milled at least two times on a three-roll mill using a gap setting less than 0.5 mil between each roll. The paste was considered adequately milled when no particles larger than 10 µm were observed in a Hegeman gauge test. This product was allowed to age in the dark for at least 24 hours prior to checking rheology or testing for material properties.

This adhesive composition can be used to seal various types of optoelectronic devices in which substrates such as glass, metal, or polymeric films are bonded. In this example, sodalime glass die were bonded to sodalime glass substrates to simulate a perimeter sealed "glass-to-giass" OLED device. Adhesive was dispensed onto a PTFE-coated Al substrate, and a ca. 4 mil film was formed using a drawdown bar. Glass die were placed on this wet film, removed, and subsequently placed on a cleaned glass substrate with light pressure to simulate a "pick and place" type robotic packaging process.

Samples were then inverted and irradiated with UV light through the glass substrate to produce a cured glass-to-glass bond. UV curing was performed in a Dymax stationary curing unit. The UV dose was 3J UVA/cm², at an intensity of ca. 45 mW UVA/cm² as measured using an EIT compact radiometer. <Similar samples can be assembled to simulate glass-to-metal bonding also common for packaging OLED and other optoelectronic devices.)

The physical properties of the uncured and cured formulation are as follows:

| TABLE 8. PHYSICAL PROPERTIES OF EPOXY/CYCLOALIPHATIC VINYL ETHER BARRIER SEALANT | |
|---|---|
| Rheology: Viscosity (η) was measured on a | η at 10 rpm = 12,800cP |
| Brookfield cone and plate viscometer at 25°C using a CP-51 spindle. | η at 1 rpm = 38,000cP |
| Thixotropic index: η at 1 rpm/η at 10 rpm. | 3.0 |
| Water Vapor Permeation Coefficient (P) (equilibrium bulk moisture permeation coefficient) was measured using a Mocon Permatran-W 3/33 instrument at 50°C and 100% relative humidity. | P = 3.0 g.mil/100 in².day |
| Adhesion was measured as die shear | DSS = 38.7 kg force |
| strength (DSS) at 25°C using a 4mmx4mm | (avg. dev. from mean= |
| UV-ozone cleaned sodalime glass die on UV-ozone cleaned sodalime glass substrate. Cure schedule: | 6.7 kg) |
| UV dose was 3J UVA at 50mW/cm² UVA; no thermal annealing; dayour ambient dwell between curing and shear testing. | |
| Cured film thermogravemetric analysis (TGA) | Weight loss: |
| weight loss was measured on a 4 mil thick | at 40°C/1hour = 0.15%; |
| film sample. | at 70°C/1hour = 0.21%; |
| Cure schedule: | at 100ºC/1hour = 0.32%. |
| UV dose was 3J UVA at 50mW/cm² UVA; no thermal bump. | |
| Viscoelastic analysis was measured as glass | T_{g} = 110°C |
| transition temperature (T_{g}) and Young's modulus (E') by dynamic mechanical analysis; tensile rectangle geometry, frequency at 10 Hz. | E' (25 °C) = 5 x 10⁹ Pa (approx.) |
| Saturation Moisture Uptake was measured on a thin film sample at 85°C and 85% RH. | <0.6 wt. % |

These properties reflect several benefits of the cycloaliphatic vinyl ether (CAVE) component of the UV-curable barrier sealant formula. In the uncured product, CAVE serves as a low viscosity multifunctional component (low formulation viscosity allows for high inorganic filler loading) with low volatility and low odor. In the cured state, CAVE contributes hydrophobicity (as evidenced by low saturation moisture uptake/weight gain at 85°C/85% RH), good crosslink density due to its low equivalent weight and multifunctionality (as evidenced by its relatively high T_{g} for a UV cured formulation and the excellent shear adhesion strength of the formulation), excellent UV reactivity (evidenced by low TGA weight loss of cured films), and a bulk moisture permeation coefficient lower than currently available perimeter sealant products known to the inventors. The improved moisture barrier properties arise from the material's high crosslink density and rigid backbone (low permeant mobility) combined with the overall hydrophobicity of the composite (low permeant solubility).

EXAMPLE 5. CYCLOALIPHATIC ACRYLIC-BASED UV CURABLE MOISTURE BARRIER SEALANT COMPOSITION

The materials shown in Table 9 were compounded to produce a radically curable thiol-acrylate based moisture barrier adhesive:

| TABLE 9. THIOL-ACRYLATE BARRIER COMPOSITION | |
|---|---|
| RESIN/FILLER | PARTS BY WEIGHT |
| DCPDDA | 47 |
| thiol, Q43 | 2 |
| Photoinitiator | 1 |
| talc filler | 50 |

The diacrylate (DCPDDA), thiol (Q43), and photoinitiator (Irgacure 651) were combined and stirred magnetically to dissolve the photoinitiator. To this resins system was added 50 parts by weight of talc as a filler. The resin/filler blend was handmixed, followed by mixing in a Speedmixer DAC 150 FV2-K (FlackTek Inc.) for one minute at 2000 rpm and one minute at 300 rpm.

The paste was coated onto release-coated PET film using a drawdown bar, and the resulting wet film was placed in a nitrogen-purged chamber for five minutes prior to UV curing. The film was cured in a Dymax stationary curing unit. UV dose was 3J UVA/cm², at an intensity of ca. 45 mW UVA/cm² as measured using an EIT compact radiometer. The equilibrium bulk moisture permeation coefficient was measured using a Mocon Permatran-W 3/33 instrument at 50°C/100% relative humidity (RH). The permeation coefficient at these conditions was determined to be 4.1 g.mil/100in².day, which indicates excellent bulk moisture barrier performance relative to typical UV-curable acrylic materials.

This adhesive composition can be used to seal various types of optoelectronic devices that bond substrates such as glass, metal, or polymeric films. As an example, sodalime glass die were bonded to sodalime glass substrates to simulate a perimeter sealed "glass-to-glass" OLED device. Adhesive was dispensed onto a PTFE-coated Al substrate, and a ca. 4 mil film was formed using a drawdown bar. Glass die were placed on this wet film, removed, and subsequently placed on a glass substrate with light pressure to simulate a "pick and place" type packaging process.

Samples were then inverted and irradiated through the glass substrate to produce a cured glass-to-glass bond. UV curing was performed in a Dymax stationary curing unit. UV dose was 3J UVAlcm², at an intensity of ca. 45 mW UVA/cm² as measured using an EIT compact radiometer. The glass-to-glass die shear strength of the cured composition was 21.6 kg force (standard deviation=3.7 kg). Similar samples can be assembled to simulate glass-to-metal bonding also common for packaging OLED and other optoelectronic devices.

EXAMPLE 6. BARRIER PERFORMANCE OF UV CURABLE LIQUID BISMALEIMIDES

Two radically curable liquid bismaleimide-based formulations were made using the components listed in Table 10. When a discrete photoinitiator was used (formulas 16 and 18), it was dissolved in the respective bismaleimide resin with magnetic stirring. Drawdown films of the formulations were made on release-coated Mylar substrates or on PTFE-coated aluminum plates. These films were UV cured in a Dymax stationary curing unit. UV dose was 3J UVA/cm², at an intensity of ca. 45 mW UVA/cm² as measured using an EIT compact radiometer. The cured films were then removed from the release Mylar or PTFE substrate. The equilibrium bulk moisture permeation coefficient was measured using a Mocon Permatran-W 3/33 instrument at 50°C/100% relative humidity (RH).

| TABLE 10. UV CURABLE LIQUID BISMALEIMIDE BARRIERS | | | | |
|---|---|---|---|---|
| FORMULA NUMBER | LIQUID BISMALEIMIDE | MALEIMIDE EQUIVALENT WEIGHT | PHOTOINITIATOR | MOISTURE PERMEATION COEFFICIENT AT 50°C/100% RH |
| | | (G/MOL) | | (gram.mil/100ln².day) |
| 15 | 100 parts | | none | 47.9 |
| | BMI-1 | | | |
| 16 | 98 parts | | 2 parts | 49.8 |
| | BMI-1 | | Irgacure 651 | |
| 17 | 100 parts | | none | 18.7 |
| | BMI-4 | | | |
| 18 | 98 parts | | 2 parts | 19.3 |
| | BMI-4 | | Irgacure 651 | |

BMI-1 has the following structure:

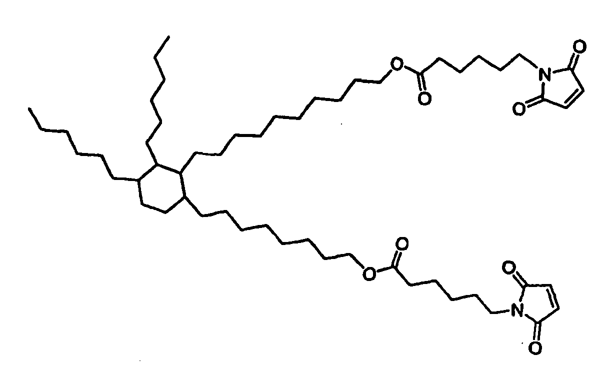

BMI-4 has the following structure:

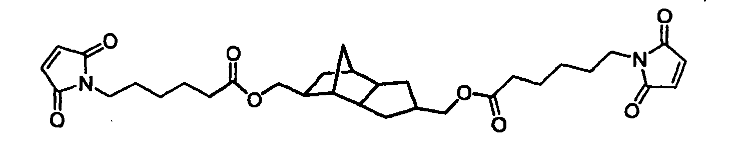

From this simple comparison it is clear that the lower equivalent weight and higher crosslink density of the BMI-4 bismaleimide (formulation 18) produced superior barrier performance relative to the BMI-1 formulations (formulations 16), which possess lower crosslink density. It is possible that the cycloaliphatic backbone present in the BMI-4 formulation also contributed to improved moisture barrier performance, although crosslink density is likely the dominant difference in these examples. It is not entirely clear why the films cured without photoinitiator (formulations 15 and 17) exhibited slightly lower bulk permeability relative to analogous formulations incorporating a radical photoinitiator (formulations 16 and 18).

The inventors note that the formulations that incorporate a discrete photoinitiator likely polymerize/crosslink predominantly through a standard radical chain polymerization mechanism, whereas the formulations that do not contain discrete photoinitiator are expected to polymerize/chain extend primarily *via* a [2+2] cycloaddition process. These different polymerization mechanisms will produce different cured matrices, which would be expected to exhibit different transmission rates due to differences in crosslink density and/or morphology. Mixed modes of polymerization likely occur in both cases, but these details were not further Investigated in this case and are not critical to the basic conclusions and trends regarding moisture permeability vs. equivalent weight and backbone structure noted above.

EXAMPLE 7. AROMATIC EPOXY/CYCLOALIPHATIC EPOXY-BASED UV-CURABLE MOISTURE BARRIER SEALANT COMPOSITION

A syringe dispensable, UV-curable barrier sealant was formulated under short wavelength-visible filtered lighting using the components as shown in Table 11.

| TABLE 11. AROMATIC EPOXY/CYCLOALIPHATIC EPOXY BARRIER SEALANT | |
|---|---|
| RESIN/FILLER | PARTS BY WEIGHT |
| Liquid aromatic epoxy | 42.59 |
| Limonene dioxide (LDO) | 8.00 |
| Silane adhesion promoter | 0.13 |
| Photoinitiator | 1.00 |
| Isopropyl thioxanthone (ITX) | 0.02 |
| Epoxy siloxane | 2.67 |
| Talc | 45.59 |

The resin components were combined and mixed to dissolve the ITX photosensitizer. The talc filler was subsequently added and hand mixed until bulk wet-out was obtained. The paste was then milled at least two times on a three-roll mill using a gap setting less than 0.5 mil between each roll. The paste was considered adequately milled when no particles larger than 20 µm were observed in a Hegeman gauge test. This product was allowed to age in the dark at least 24 hours prior to checking rheology or testing for material properties.

This adhesive composition can be used to seal various types of optoelectronic devices in which substrates such as glass, metal, or polymeric films are bonded. In this example, sodalime glass die were bonded to sodalime glass substrates to simulate a perimeter sealed "glass-to-glass" OLED device. Adhesive was dispensed onto a PTFE-coated Al substrate, and a ca. 4 mil film was formed using a drawdown bar. Glass die were placed on this wet film, removed, and subsequently placed on a cleaned glass substrate with light pressure to simulate a "pick and place" type robotic packaging process.

Samples were then inverted and irradiated with UV light through the glass substrate to produce a cured glass-to-glass bond. UV curing was performed in a Dymax stationary curing unit. The UV dose was 3J UVA/cm², at an intensity of ca. 45 mW UVA/cm² as measured using an EIT compact radiometer. (Similar samples can be assembled to simulate glass-to-metal bonding also common for packaging OLED and other optoelectronic devices.)

The physical properties of the uncured and cured composition were obtained as shown in Table 12.

| TABLE 12. PHYSICAL PROPERTIES OF AROMATIC EPOXY/CYCLOALIPHATIC EPOXY BARRIER SEALANT | |
|---|---|
| Rheology: Viscosity (η) was measured on a | η at 10 rpm. = 12,730 cP |
| Brookfield cone and plate viscometer at 25°C using a CP-51 spindle | η at 1 rpm = 24,680 cP |
| Thixotropic index: η at 1 rpm/η at 10 rpm | 1.9 |
| Water Vapor Permeation Coefficient (P) | P = 6.5 g.mil/100 in².day |
| (equilibrium bulk moisture permeation coefficient) was measured using a Mocon Permatran-W 3/33 instrument at 50°C and 100% relative humidity | |
| Adhesion was measured as die shear strength (DSS) at 25°C using a 4mmx4mm UV-ozone cleaned sodalime glass die on UV-ozone cleaned sodalime glass substrate. | DSS = 15.3 kg force (std. devlatlon=2.9 kg). |
| Cure schedule: | |
| UV dose was 3J UVA at 50mW/cm² UVA; no thermal annealing; 24 hour ambient dwell between curing and shear testing | |
| Cured film thermogravimetric analysis (TGA) | Weight loss: |
| weight loss was measured on a 4 mil thick | at 40°C/1 hour = 0.5 %; |
| film sample. | at 70°C/1 hour = 0.5%; |
| Cure schedule: | at 100°C/1 hour = 0.5%. |
| UV dose was 3J UVA at 50mW/cm² UVA; no thermal bump | |
| Viscoelastic analysis was measured as glass | T_{g} = 120°C |
| transition temperature (T_{g}) and Young's modulus (E') by dynamic mechanical analysis; tensile rectangle geometry, frequency at 10 Hz. | E'(25 °C)= 1.5 x 10⁹ Pa (approx.) |
| Saturation Moisture Uptake was measured on a thin film sample at 85°C and 85% RH | 1.0 wt. %. |

## Claims

1. A radiation curable barrier sealant comprising
(a) a curable resin **characterized in that** it
(i) has a cycloaliphatic backbone,
(ii) has at least one reactive functional group present at a level that provides an equivalent weight of less than 400 grams per mole of reactive functional.group, and
(b) an initiator,
in which the cycloaliphatic resin is selected from the group consisting of 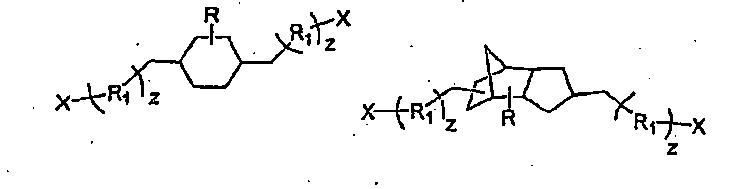 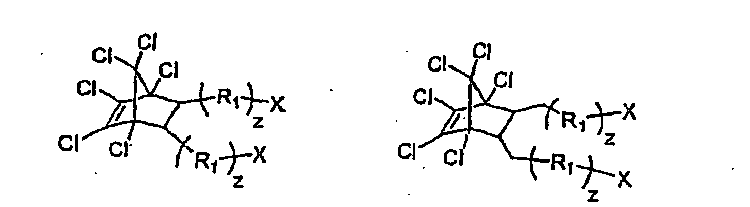 and
in which
X is a reactive group independently selected from glycidyl epoxy, aliphatic epoxy, and cycloaliphatic epoxy; itaconate; maleimide; vinyl, propenyl, crotyl, allyl, and propargyl ether, and the thio-ethers of those groups; maleate, fumarate, and cinnamate esters; styrenic; acrylamide and methacrylamide; chalcone; thiol; allyl, alkenyl, and cycloalkenyl;
R is hydrogen, alkyl, or halogen;
R₁ is linear alkyl, branched alkyl, or cycloalkyl, and may contain heteroatoms, and z is 0 or 1.

2. The curable barrier sealant according to claim 1 in which the reactive group X on the radiation-curable resin is vinyl ether.

3. The curable barrier sealant according to claim 2 in which the radiation-curable resin is 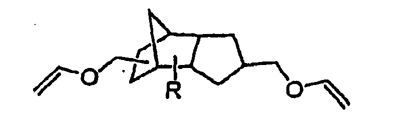 in which R is hydrogen, alkyl or halogen.

4. The curable barrier sealant according to claim 3 in which the curable resin is

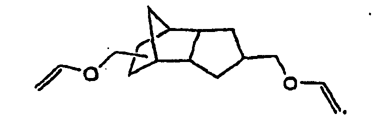

5. The curable barrier sealant according to claim 1 in which the cycloaliphatic resin is selected from the group consisting of 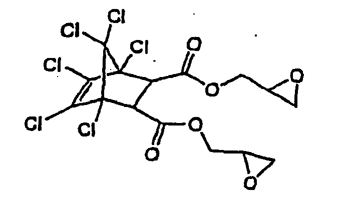 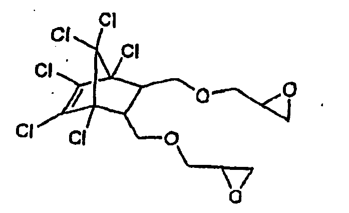 and

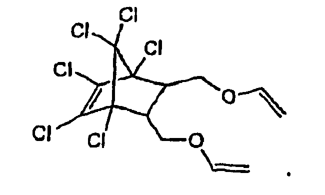

6. The curable barrier sealant according to any one of claims 1 through 5 further comprising (c) a resin that does not contain a cycloaliphatic backbone.

7. The curable barrier sealant according to any one of claims 1 through 5 further comprising (d) a filler.

8. The curable barrier sealant according to any one of claims 1 through 5 further comprising (c) a resin that does not contain a cycloaliphatic backbone and (d) a filler.

9. An electronic or optoelectronic device sealed with a radiation curable barrier sealant comprising
(a) a curable resin **characterized in that** it
(i) has a cycloaliphatic backbone,
(ii) has at least one reactive functional group present at a level that provides an equivalent weight of less than 400 grams per mole of reactive functional group, and
(b) an initiator.
in which the cycloaliphatic resin is selected from the group consisting of 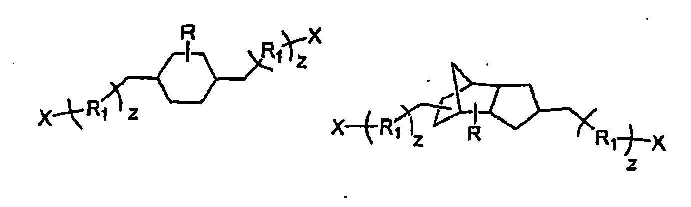 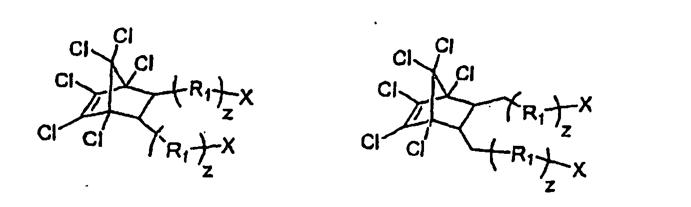 and
in which
X is a reactive group independently selected from glycidyl epoxy, aliphatic epoxy, and cycloaliphatic epoxy; acrylate and methacrylate; itaconate; maleimide; vinyl, propenyl, crotyl, allyl, and propargyl ether, and the thio-ethers of those groups; maleate, fumarate, and cinnamate esters; styrenic; acrylamide and methacrylamide, chalcone; thiol; allyl, alkenyl, an cycloalkenyl;
R is hydrogen, alkyl, or halogen;
R₁ is linear alkyl, branched alkyl, or cycloalkyl, and may contain heteroatoms,
and z is 0 or 1.

10. The electronic or optoelectronic device according to claim 9 in which the reactive group X on the radiation-curable resin is vinyl ether or acrylate.

11. The electronic or optoelectronic device according to claim 10 in which the radiation-curable resin is 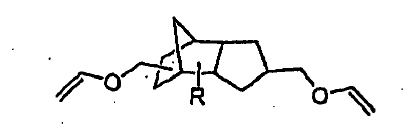 in which R is hydrogen, alkyl or halogen.

12. The electronic or optoelectronic device according to claim 11 in which the curable resin is

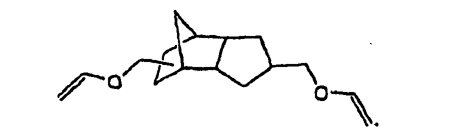

13. The electronic or optoelectronic device according to claim 10, in which the curable resin is 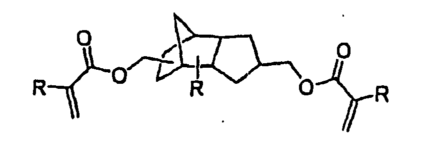 in which R is hydrogen, alkyl, or halogen.

14. The electronic or optoelectronic device according to claim 13, in which the curable resin is

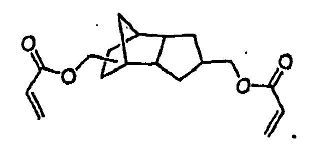

15. The electronic or optoelectronic device according to claim 9 in which the cycloaliphatic resin is selected from the group consisting of 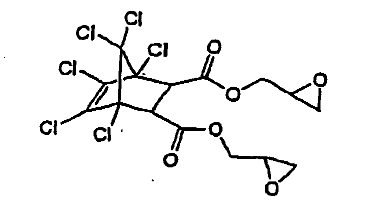 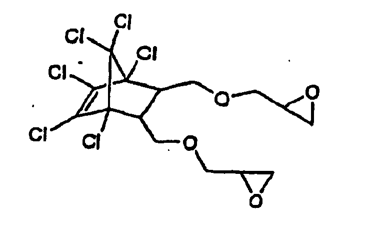 and

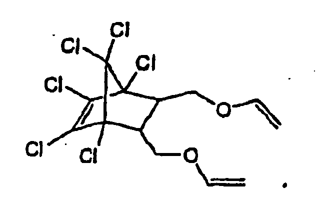

16. An electronic or optoelectronic device according to any one of claim 9 through 15, wherein the radiation curable barrier sealant further comprises (c) a resin that does not contain a cycloaliphatic backbone.

17. An electronic or optoelectronic device according to any one of claims 9 through 15, wherein the radiation curable barrier sealant further comprises (d) a filler.

18. An electronic or optoelectronic device according to any one of claims 9 through 15, wherein the radiation curable barrier sealant further comprises (c) a resin that does not contain a cycloaliphatic backbone and (d) a filler.

19. An optoelectronic device according to any one of claims 9 through 15, which is an OLED.

## Patentansprüche

1. Strahlungshärtbarer Sperrdichtstoff umfassend
(a) ein härtbares Harz, **dadurch gekennzeichnet, dass** es
(i) eine cycloaliphatische Hauptkette hat,
(ii) mindestens eine reaktive funktionelle Gruppe hat, die in einer Menge vorhanden ist, die ein äquivalentes Gewicht von unter 400 Gramm pro Mol der reaktiven funktionellen Gruppe ergibt, und
(b) einen Initiator,
bei welchem das cycloaliphatische Harz ausgewählt ist aus der Gruppe bestehend aus 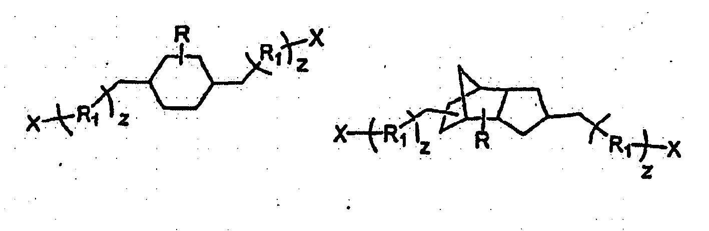 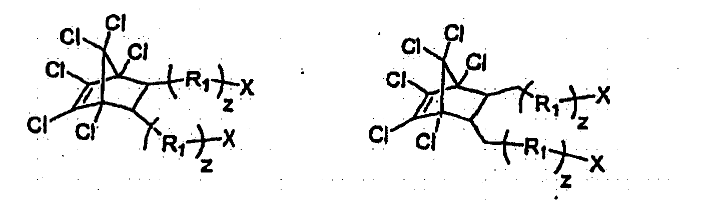 und
bei welchem
X eine reaktive Gruppe ist, die unabhängig ausgewählt ist aus Glycidylepoxid, aliphatischem Epoxid und cycloaliphatischem Epoxid; Itaconat; Maleimid; Vinyl-, Propenyl-, Crotyl-, Allyl- und Propargylether sowie den Thioethern dieser Gruppen; Maleat-, Fumarat- und Cinnamatestern; styrolisch;
Acrylamid und Methacrylamid; Chalkon; Thiol; Allyl, Alkenyl und Cycloalkenyl;
R Wasserstoff, Alkyl oder Halogen ist;
R₁ unverzweigtes Alkyl, verzweigtes Alkyl oder Cycloalkyl ist und Heteroatome enthalten kann, und
z 0 oder 1 ist.

2. Härtbarer Sperrdichtstoff nach Anspruch 1, bei welchem die reaktive Gruppe X am strahlungshärtbaren Harz Vinylether ist.

3. Härtbarer Sperrdichtstoff nach Anspruch 2, bei welchem das strahlungshärtbare Harz 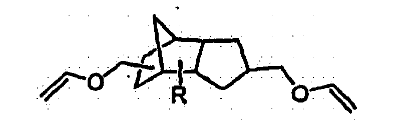 ist,
bei welchem R Wasserstoff, Alkyl oder Halogen ist.

4. Härtbarer Sperrdichtstoff nach Anspruch 3, bei welchem das härtbare Harz 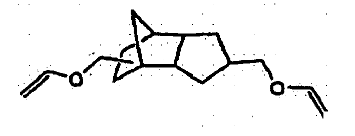 ist.

5. Härtbarer Sperrdichtstoff nach Anspruch 1, bei welchem das cycloaliphatische Harz ausgewählt ist aus der Gruppe bestehend aus 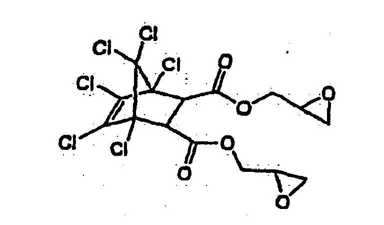 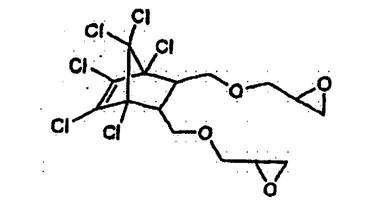 und

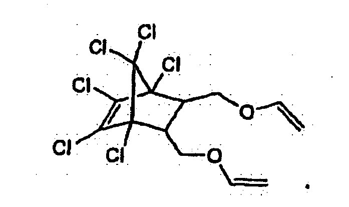

6. Härtbarer Sperrdichtstoff nach irgendeinem der Ansprüche 1 bis 5, ferner umfassend (c) ein Harz, das keine cycloaliphatische Hauptkette enthält.

7. Härtbarer Sperrdichtstoff nach irgendeinem der Ansprüche 1 bis 5, ferner umfassend (d) einen Füllstoff.

8. Härtbarer Sperrdichtstoff nach irgendeinem der Ansprüche 1 bis 5, ferner umfassend (c) ein Harz, das keine cycloaliphatische Hauptkette enthält, und (d) einen Füllstoff.

9. Elektronische oder optoelektronische Vorrichtung, abgedichtet mit einem strahlungshärtbaren Sperrdichtstoff umfassend
(a) ein härtbares Harz, **dadurch gekennzeichnet, dass** es
(i) eine cycloaliphatische Hauptkette hat,
(ii) mindestens eine reaktive funktionelle Gruppe hat, die in einer Menge vorhanden ist, die ein äquivalentes Gewicht von unter 400 Gramm pro Mol der reaktiven funktionellen Gruppe ergibt, und
(b) einen Initiator,
bei welchem das cycloaliphatische Harz ausgewählt ist aus der Gruppe bestehend aus 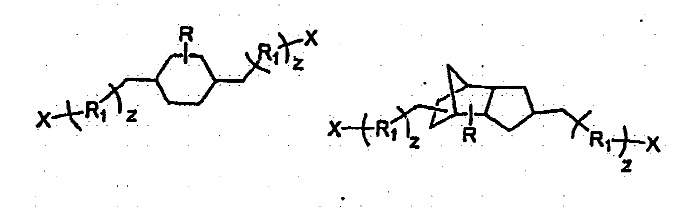 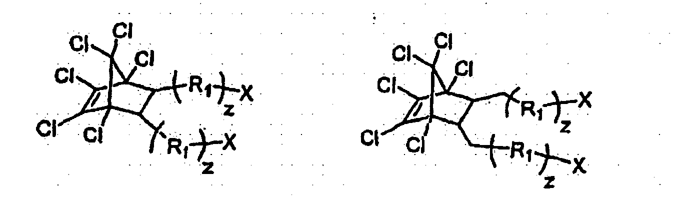 und
bei welchem
X eine reaktive Gruppe ist, die unabhängig ausgewählt ist aus Glycidylepoxid, aliphatischem Epoxid und cycloaliphatischem Epoxid; Acrylat und Methacrylat; Itaconat; Maleimid; Vinyl-, Propenyl-, Crotyl-, Allyl- und Propargylether sowie den Thioethern dieser Gruppen; Maleat-, Fumarat- und Cinnamatestern; styrolisch; Acrylamid und Methacrylamid; Chalkon; Thiol; Allyl, Alkenyl und Cycloalkenyl;
R Wasserstoff, Alkyl oder Halogen ist;
R₁ unverzweigtes Alkyl, verzweigtes Alkyl oder Cycloalkyl ist und Heteroatome enthalten kann, und
z 0 oder 1 ist.

10. Elektronische oder optoelektronische Vorrichtung nach Anspruch 9, bei welcher die reaktive Gruppe X am strahlungshärtbaren Harz Vinylether oder Acrylat ist.

11. Elektronische oder optoelektronische Vorrichtung nach Anspruch 10, bei welcher das strahlungshärtbare Harz 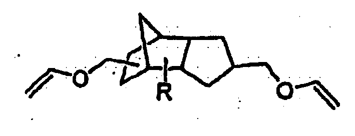 ist,
bei welchem R Wasserstoff, Alkyl oder Halogen ist.

12. Elektronische oder optoelektronische Vorrichtung nach Anspruch 11, bei welcher das härtbare Harz 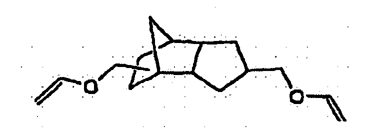 ist.

13. Elektronische oder optoelektronische Vorrichtung nach Anspruch 10, bei welcher das härtbare Harz 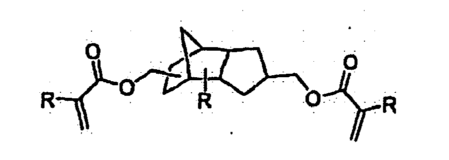 ist,
bei welchem R Wasserstoff, Alkyl oder Halogen ist.

14. Elektronische oder optoelektronische Vorrichtung nach Anspruch 13, bei welcher das härtbare Harz 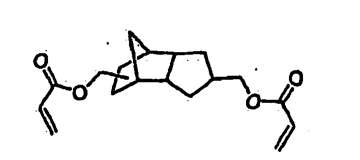 ist.

15. Elektronische oder optoelektronische Vorrichtung nach Anspruch 9, bei welcher das cycloaliphatische Harz ausgewählt ist aus der Gruppe bestehend aus 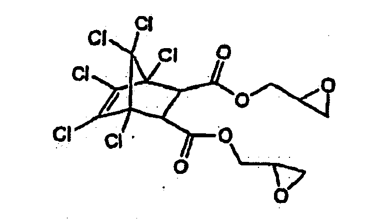 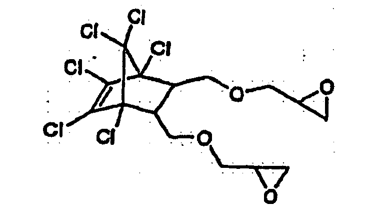 und

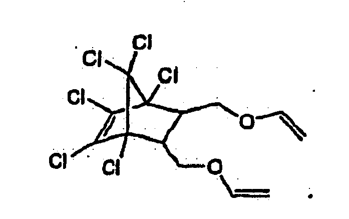

16. Elektronische oder optoelektronische Vorrichtung nach irgendeinem der Ansprüche 9 bis 15, wobei der strahlungshärtbare Sperrdichtstoff ferner (c) ein Harz umfasst, das keine cycloaliphatische Hauptkette enthält.

17. Elektronische oder optoelektronische Vorrichtung nach irgendeinem der Ansprüche 9 bis 15, wobei der strahlungshärtbare Sperrdichtstoff ferner (d) einen Füllstoff umfasst.

18. Elektronische oder optoelektronische Vorrichtung nach irgendeinem der Ansprüche 9 bis 15, wobei der strahlungshärtbare Sperrdichtstoff ferner (c) ein Harz, das keine cycloaliphatische Hauptkette enthält, und (d) einen Füllstoff umfasst.

19. Optoelektronische Vorrichtung nach irgendeinem der Ansprüche 9 bis 15, welche eine OLED ist.

## Revendications

1. Agent d'étanchéité faisant office de barrière durcissable par exposition à un rayonnement, comprenant
(a) une résine durcissable **caractérisée en ce que**
(i) elle possède un squelette cycloaliphatique ;
(ii) elle possède au moins un groupe fonctionnel réactif présent à un niveau tel qu'il fournit un poids équivalent inférieur à 400 g par mole du groupe fonctionnel réactif, et
(b) un initiateur
dans lequel la résine cycloaliphatique est choisie parmi le groupe constitué par 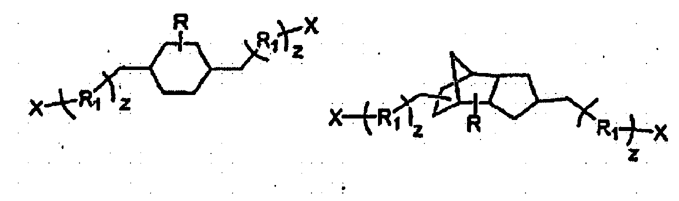 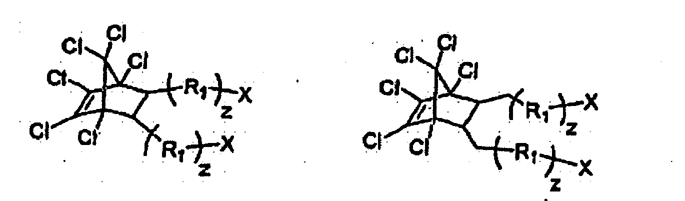 **et**
dans lequel
X représente un groupe réactif choisi, de manière indépendante, parmi un groupe glycidylépoxy, un groupe époxy aliphatique et un groupe époxy cycloaliphatique ; un groupe itaconate ; un groupe maléimide ; un éther vinylique, un éther propénylique, un éther crotylique, un éther allylique et un éther propargylique, ainsi que les thioéthers de ces groupes ; des esters maléates, fumarates et cinnamates ; un composé styréné ; un groupe acrylamide et un groupe méthacrylamide ; un groupe chalcone ; un groupe thiol ; un groupe allyle, un groupe alcényle et un groupe cycloalcényle ;
R représente un atome d'hydrogène, un groupe alkyle ou un atome d'halogène ;
R₁ représente un groupe alkyle linéaire, un groupe alkyle ramifié ou un groupe cycloalkyle, et peut contenir des hétéroatomes ; et
z est égal à 0 ou 1.

2. Agent d'étanchéité durcissable faisant office de barrière selon la revendication 1, dans lequel le groupe réactif X sur la résine durcissable par exposition à un rayonnement est l'éther vinylique.

3. Agent d'étanchéité durcissable faisant office de barrière selon la revendication 2, dans lequel la résine durcissable par exposition à un rayonnement est 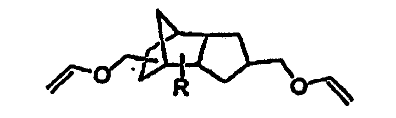 dans laquelle R représente un atome d'hydrogène, un groupe alkyle ou un atome d'halogène.

4. Agent d'étanchéité durcissable faisant office de barrière selon la revendication 3, dans lequel la résine durcissable est

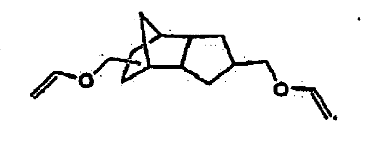

5. Agent d'étanchéité durcissable faisant office de barrière selon la revendication 1, dans lequel la résine cycloaliphatique est choisie parmi le groupe constitué par 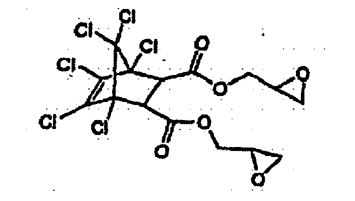 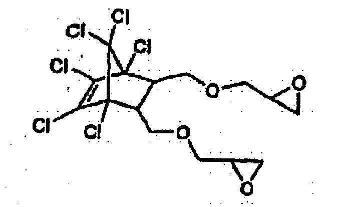 **et**

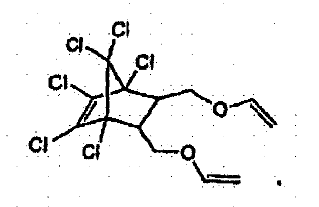

6. Agent d'étanchéité durcissable faisant office de barrière selon l'une quelconque des revendications 1 à 5, comprenant en outre (c) une résine qui ne contient pas un squelette cycloaliphatique.

7. Agent d'étanchéité durcissable faisant office de barrière selon l'une quelconque des revendications 1 à 5, comprenant en outre (d) une matière de charge.

8. Agent d'étanchéité durcissable faisant office de barrière selon l'une quelconque des revendications 1 à 5, comprenant en outre (c) une résine qui ne contient pas un squelette cycloaliphatique et (d) une matière de charge.

9. Dispositif électronique ou optoélectronique rendu étanche avec un agent d'étanchéité faisant office de barrière durcissable par exposition à un rayonnement, comprenant :
(a) une résine durcissable **caractérisée en ce que**
(i) elle possède un squelette cycloaliphatique ;
(ii) elle possède au moins un groupe fonctionnel réactif présent à un niveau tel qu'il fournit un poids équivalent inférieur à 400 g par mole du groupe fonctionnel réactif, et
(b) un initiateur
dans lequel la résine cycloaliphatique est choisie parmi le groupe constitué par 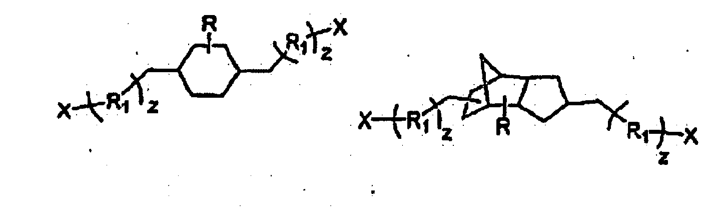 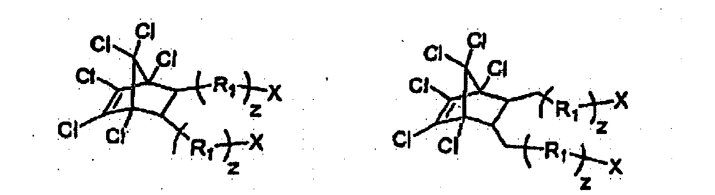 **et**
dans lequel
X représente un groupe réactif choisi, de manière indépendante, parmi un groupe glycidylépoxy, un groupe époxy aliphatique et un groupe époxy cycloaliphatique ; un groupe acrylate et un groupe méthacrylate ; un groupe itaconate ; un groupe maléimide ; un éther vinylique, un éther propénylique, un éther crotylique, un éther allylique et un éther propargylique, ainsi que les thioéthers de ces groupes ; des esters maléates, fumarates et cinnamates ; un composé styréné ; un groupe acrylamide et un groupe méthacrylamide ; un groupe chalcone ; un groupe thiol ; un groupe allyle, un groupe alcényle, un groupe cycloalcényle ;
R représente un atome d'hydrogène, un groupe alkyle ou un atome d'halogène ;
R₁ représente un groupe alkyle linéaire, un groupe alkyle ramifié ou un groupe cycloalkyle, et peut contenir des hétéroatomes ; et
z est égal à 0 ou 1.

10. Dispositif électronique ou optoélectronique selon la revendication 9, dans lequel le groupe réactif X sur la résine durcissable par exposition à un rayonnement est l'éther vinylique ou un acrylate.

11. Dispositif électronique ou optoélectronique selon la revendication 10, dans lequel la résine durcissable par exposition à un rayonnement est 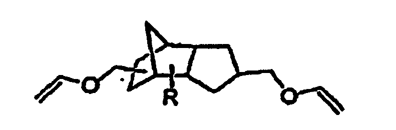 dans laquelle R représente un atome d'hydrogène, un groupe alkyle ou un atome d'halogène.

12. Dispositif électronique ou optoélectronique selon la revendication 11, dans lequel la résine durcissable est

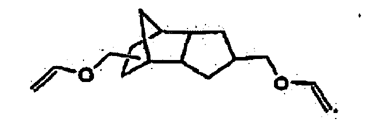

13. Dispositif électronique ou optoélectronique selon la revendication 10, dans lequel la résine durcissable est 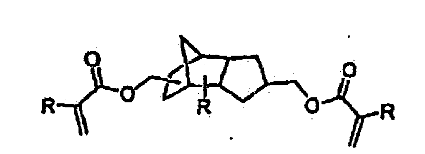 dans laquelle R représente un atome d'hydrogène, un groupe alkyle ou un atome d'halogène.

14. Dispositif électronique ou optoélectronique selon la revendication 13, dans lequel la résine durcissable est

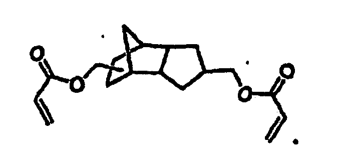

15. Dispositif électronique ou optoélectronique selon la revendication 9, dans lequel la résine cycloaliphatique est choisie parmi le groupe constitué par 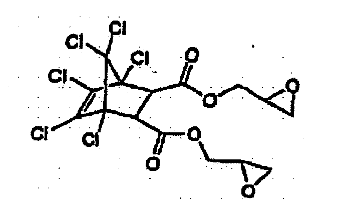 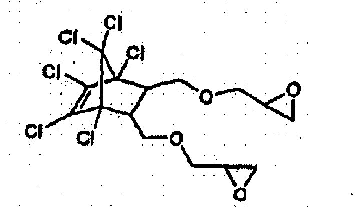 **et**

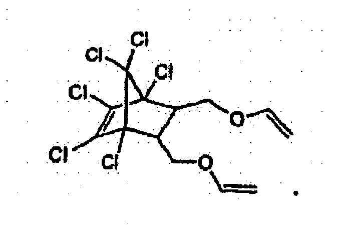

16. Dispositif électronique ou optoélectronique selon l'une quelconque des revendications 9 à 15, dans lequel l'agent d'étanchéité faisant office de barrière durcissable par exposition à un rayonnement comprend en outre (c) une résine qui ne contient pas un squelette cycloaliphatique.

17. Dispositif électronique ou optoélectronique selon l'une quelconque des revendications 9 à 15, dans lequel l'agent d'étanchéité faisant office de barrière durcissable par exposition à un rayonnement comprend en outre (d) une matière de charge.

18. Dispositif électronique ou optoélectronique selon l'une quelconque des revendications 9 à 15, dans lequel l'agent d'étanchéité faisant office de barrière durcissable par exposition à un rayonnement comprend en outre (c) une résine qui ne contient pas un squelette cycloaliphatique et (d) une matière de charge.

19. Dispositif optoélectronique selon l'une quelconque des revendications 9 à 15, qui est un OLED.
